Europäisches Patentamt

European Patent Office

Office européen des brevets

(19)

(11) EP 0 649 174 B1

(12) EUROPEAN PATENT SPECIFICATION

(45) Date of publication and mention
of the grant of the patent:
**20.05.1998 Bulletin 1998/21**

(51) Int Cl.⁶: **H01L 29/423**, H01L 29/76, H01L 27/092

(21) Application number: **94307587.9**

(22) Date of filing: **17.10.1994**

(54) **Controllable conduction device with multiple tunnel junction**

Bauelement mit kontrollierbarer Leitung und mit Mehrfachtunnelübergang

Dispositif à conduction contrôlable avec une jonction tunnel multiple

(84) Designated Contracting States:
**DE FR GB IT NL**

(30) Priority: **15.10.1993 GB 9321326**

(43) Date of publication of application:
**19.04.1995 Bulletin 1995/16**

(73) Proprietor: **HITACHI EUROPE LIMITED
Maidenhead, Berkshire, SL6 8YA (GB)**

(72) Inventor: **Nakazato, Kazuo
Cambridge, CB1 4PA (GB)**

(74) Representative: **Read, Matthew Charles et al
Venner Shipley & Co.
20 Little Britain
London EC1A 7DH (GB)**

(56) References cited:
**EP-A- 0 389 761          FR-A- 2 676 308**

- **ZEITSCHRIFT FüR PHYSIK B: CONDENSED MATTER, vol.85, 1991 pages 375 - 380 D.C. GLATTLI ET AL.**

## Description

This invention relates to a controllable conduction device that includes a multiple tunnel junction and has particular application to switching devices such as FET transistors.

In a conventional FET transistor or similar controlled conduction devices, current flows from a source to a drain through an electron channel under the control of a gate. In the on state, a mass of electrons flows through the FET channel. In the off state the current reduces to a level approaching zero but many electrons still flow, resulting in a so-called leakage current. This leakage current is an impediment to miniaturization of large scale integrated circuits (LSIs) since there is a considerable unwanted power consumption in devices that include many thousands of transistor elements.

Much research has been directed recently to so-called quantum electronics in which nanoscale islands are used to store small numbers and in theory a single electron and a number of devices have been proposed making use of this principle. Reference is directed to K. K. Likharev, "Correlated discrete transfers of single electrons in ultrasmall tunnel junctions" IBM J. Res. Develop. 32(1) 144-158 [1988], and J.R. Tucker "Complementary digital logic based on the 'Coulomb blockade' J. Appl. Phys. 72(9), 4399-4413 [1992]. The devices operate on the principle of Coulomb blockade, which inhibits charge tunnelling onto the island. As will be explained in more detail hereinafter, for a nanoscale island, the charging energy can exceed the thermal energy of surrounding electrons so that the charging energy provides a barrier to electrons attempting to tunnel into the island and as a result, the charge on the island remains fixed so that no single electron can flow onto the island. This so-called Coulomb blockade of charge tunnelling has hitherto only been used in devices operating with small numbers of electrons and so far, has the disadvantage that the devices need to be cooled to temperatures approaching absolute zero because the islands cannot be made sufficiently small to exhibit energies which exceed the thermal energy at room temperature.

European Patent Application Publication No. 0 389 761 (corresponding to the preamble of claim 1) discloses a device which provides superlattice effects and which includes a gate finger structure the dimensions of which fall in the range 10nm - 250nm.

In accordance with the present invention, it has been appreciated that Coulomb blockade can be used with advantage in conventional devices such as field effect transistors, to control a mass charge carrier flow and reduce the conventional leakage current.

Broadly stated, in accordance with a first aspect of the invention, there is provided a controllable conduction device comprising means defining a conductive path for mass charge carrier flow and means for controlling mass charge carrier flow along the path, between relatively high and low conduction conditions, characterised by a plurality of elements spaced apart by a distance of less than 10nm and operative by Coulomb blockade to inhibit mass charge carrier flow along the path in said low conduction condition.

The Coulomb blockade means as a practical matter can be embodied as a multiple tunnel junction.

The invention can be used to improve the characteristics of a conventional field effect transistor, and in one form, the device according to the invention includes a gate to receive a control potential for controlling a mass charge carrier flow along the path and the multiple tunnel junctions are formed by a plurality of spaced fingers formed in the conductive region.

In a second aspect, the invention comprises a method of driving a controllable conduction device between relatively high and low conduction conditions, the device comprising means defining a conductive path for mass charge carrier flow, means for controlling mass charge carrier flow along the path, between relatively high and low conduction conditions, and means operative by Coulomb blockade to inhibit mass charge carrier flow along the path in said low conduction condition, such that in said low conduction condition, mass charge carrier flow along the conductive path is inhibited by the Coulomb blockade effect.

In order that the invention may be more fully understood, embodiments thereof will now be described by way of example with reference to the accompanying drawings in which:

Figure 1 is a cross-sectional view of a conventional field effect transistor (FET);
Figure 2 is a schematic voltage/current graph for the FET;
Figure 3 is a schematic illustration of a known single electron transistor;
Figure 4 is a schematic illustration of the charge configuration on the island shown in Figure 3;
Figure 5 comprises graphs showing the gate-voltage characteristic of the transistor in Figure 3;
Figure 6 illustrates the energy distribution as a function of position, in the direction x shown in Figure 3;
Figure 7 is a graph similar to that of Figure 6, showing the energy distribution as a function of position for a multiple tunnel junction (MTJ);
Figure 8 is a schematic enlarged perspective view in partial section of a controllable conduction device;
Figure 9 is a graph of the drain current to gate-voltage characteristic of the device shown in Figure 8;
Figure 10 illustrates a circuit symbol for the device according to the invention shown in Figure 8;
Figure 11 is a schematic enlarged perspective view in partial section of a complementary pair of the devices connected as an inverter;
Figure 12 shows the circuit of Figure 11 using the symbol nomenclature of Figure 10;

Figure 13 illustrates a NAND circuit; and
Figure 14 illustrates a NOR circuit.

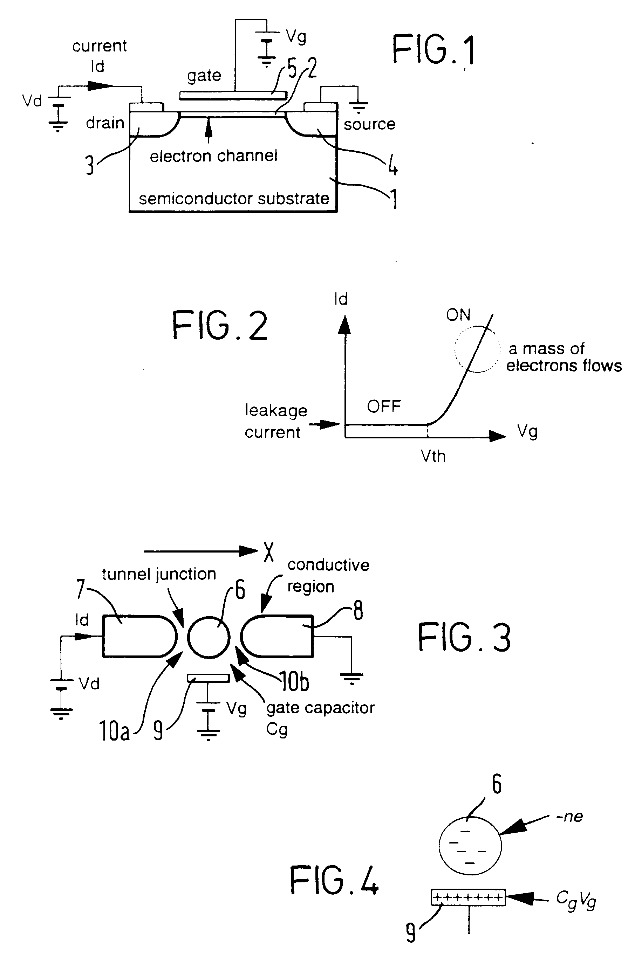

Referring firstly to Figure 1, a conventional FET will be described briefly. As is well known, a conventional FET consists of a semiconductor substrate 1 which includes an electron channel 2 that extends between source and drain regions 3, 4. Conduction in the channel 2 is controlled by means of a gate 5 which receives a gate voltage $V_g$. Thus, when the device is switched on, mass electron flow occurs along the electron channel 2 between the source and drain 3, 4 to produce a current $I_d$. The device thus operates with a conventional current produced by the mass action of a large number of electrons that drift through the device along the channel under the influence of the drain voltage $V_d$. As shown in Figure 2, when the gate voltage is reduced below a threshold $V_{th}$ the device is switched off and the current $I_d$ in the electron channel settles to a minimum value. However, the current does not reduce totally to zero because a leakage current occurs. This leakage current restricts integration of such FETs in LSI circuitry because the leakage current for many thousands of transistors integrated into a single chip, can consume a considerable amount of power.

As previously mentioned, as an alternative approach, a nano fabricated single electron transistor has been proposed and an example is shown in Figure 3. A small conducting island 6, typically 20 nm in diameter is disposed between the source and drain regions 7, 8. Electrically insulating spaces 10a, 10b between the island 6 and the source and drain 7, 8 act as tunnel junctions, that have an effect on electron transport through the device, as will be explained hereinafter. A gate region 9 shown schematically in Figure 3, is arranged to control the charge on the island 6. Thus, the island 6 and the gate 9 form a gate capacitor with a capacitance $C_g$. The charging energy of the single-electron transistor is given by

$$E = \frac{Q^2}{2C} \qquad (1)$$

where C is the capacitance of island 6 and Q is the total charge given by

$$Q = -ne + C_g V_g$$

where -ne is the charge within the island (n is a number of excess electrons in the island and -e is electronic charge), and $C_g V_g$ is the charge induced on gate 9 (Figure 4). Equation (1) means that the energy becomes minimum when the charge neutrality condition is satisfied (Q = 0). However, since the system is very small, the number of individual electrons on the island has to be considered and hence the number of electrons takes an integer value, and it is impossible to satisfy the charge neutrality condition in general.

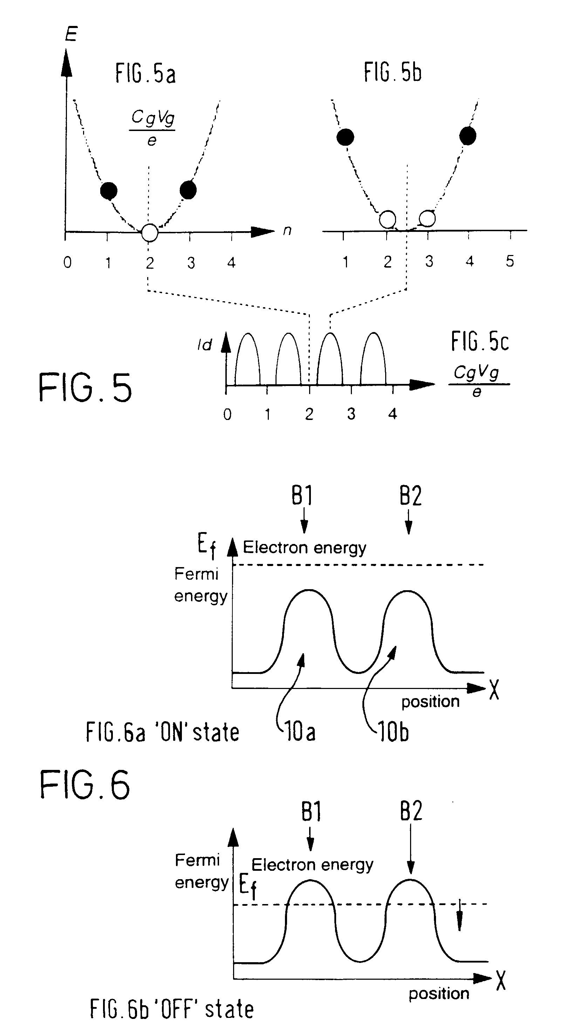

Equation (1) is plotted in Figure 5. When $C_g V_g/e$ takes an integer value n (Figure 5(a)), the charge neutrality can be satisfied perfectly, i.e. when $n = C_g V_g/e$. If one electron is added or removed from this state, the charging energy will increase. If this energy is high enough compared to thermal activation energy $k_B T$ ($k_B$ is the Boltzmann constant, T is temperature), the entrance and exit of electrons to and from the island 6 is prevented, and the number of electrons on the island is fixed. This is called the Coulomb blockade state. In this state, not even one electron can pass through the single-electron transistor.

When $C_g V_g/e$ takes a half-integer value, two states [white circles in Figure 5(b)], for which $n = C_g V_g/e +/- 1/2$, take the same energy. When the number of electrons on the island 6 is $C_g V_g/e-1/2$, one electron enters the island and the number of electrons on the island becomes $C_g V_g/e+1/2$. Then one electron exits the island and the number of electrons becomes $C_g V_g/e-1/2$ again. This means that just one electron can pass through the single-electron transistor. Since the two states are at the same energy, the passage of the electron does not involve an energy increase.

The current to gate voltage characteristic is shown in Figure 5(c) and the gate voltage can switch the electron flow.

Thus, in summary, for the single electron transistor, when $C_g V_g/e$ takes an integer value, Coulomb blockade prevents tunnelling through the tunnel junctions 10a, 10b so that no electron flow - not even a single electron, flows through the device. In the event that $C_g V_g/e$ takes a half integer value, single electrons tunnel from the source 8 through tunnel junction 10b to the island 6, and from the island 6 through tunnel junction 10a to the drain 7. Thus, electrons flow one at a time through the device, in contrast to the mass current flow of a conventional FET in the on state.

Referring to Figure 6, this shows that the energy as a function of position, in the direction x shown in Figure 3. Two potential barriers B1, B2 are provided by the tunnel junctions 10a, 10b.

In the conditions previously described (no electron flow or single electron tunnelling) hereinafter referred to as the OFF state, the Fermi energy $E_f$ is less than the barrier heights for the barriers B1, B2 as shown in Figure 6B, and hence electrons can only flow through the barriers B1, B2 by tunnelling as previously described, in which case either no electron transport will occur or single electron transport will result from tunnelling through the barriers.

However, referring to Figure 6A, if the Fermi energy is raised above the height of the barriers B1, B2, or the barriers themselves are lowered by changing the applied potentials, no charge tunnelling will occur and electrons will flow freely between the source and the drain. this is the ON state for the device.

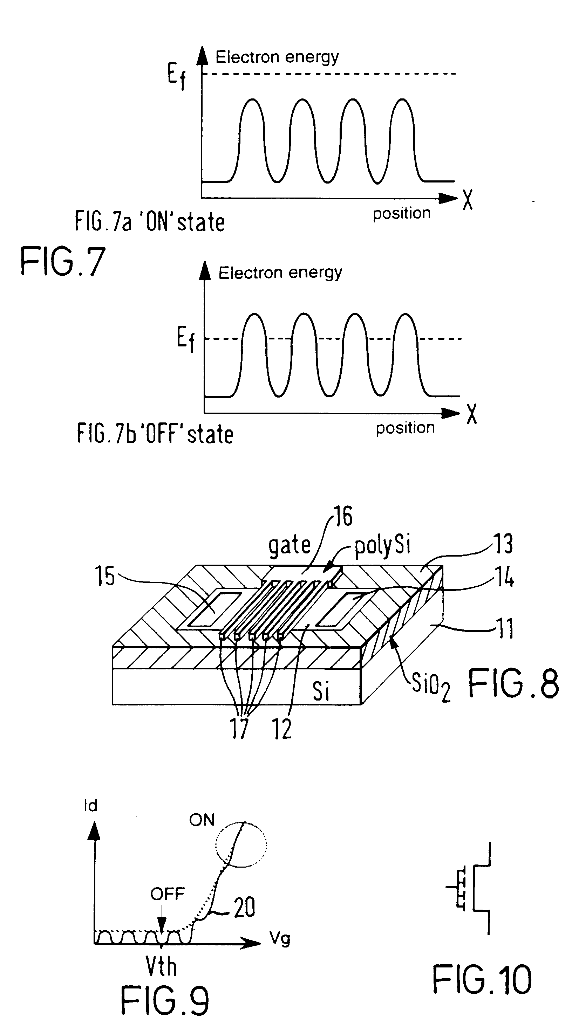

Referring now to Figure 7, this principle can be extended to a multiple tunnel junction or MTJ which includes a plurality of conductive regions corresponding to islands 6 arranged in a sequence. Thus, when the relative heights of the barriers and the Fermi level are arranged as shown in Figure 7B, the OFF state, electron transport by tunnelling can occur solely on a single electron basis or is totally blocked by Coulomb blockade, as previously described, but when the Fermi level $E_f$ is raised relative to the barrier height as shown in Figure 7A, the ON state, conventional electron transport can occur.

In accordance with the invention, it has been appreciated that this characteristic can be used at least substantially to reduce the leakage current in a conventional FET. Referring now to Figure 8, which shows an example of a controllable conduction device, a silicon substrate 11 is provided with an n-type conductive channel 12 surrounded by insulating oxide 13 and heavily doped source and drain regions 14, 15. Current flow between the source and drain regions 14,15 is controlled by means of a gate 16 formed of conductive material such as polysilicon. Alternatively, a metal layer could be used. Thus, the gate 16 can control mass current flow between the source and drain in the manner of a conventional FET. The gate 16 is additionally provided with an interdigitated structure comprising a plurality of generally parallel spaced fingers 17. The potential applied to gate 16 produces by means of the fingers 17, a series of spaced depletion regions extending transversely across the channel 12 so as to produce a multiple tunnel junction configuration in the channel. The configuration shown in Figure 8 is typically produced by conventional lithographic techniques used in the fabrication of conventional FET transistors, but the interdigitated arrangement 17 may be produced by electron beam lithography such that the fingers are typically of the order of 10 nm in width, with an equal spacing. For appropriate electron beam techniques, reference is directed to W. Chen and H. Ahmed, "Fabrication of 5-7nm wide etched lines in silicon using 100keV electron beam lithography and polymethylmethacrylate resist" Appl. Phys. Lett. vol. 62, p 1499, 1993.

The drain current to gate voltage characteristic of the device is shown in Figure 9. The characteristic of a conventional FET is shown in dotted outline and this is modified as shown in solid line 20 as a result of inclusion of the MTJ structure 17. Thus, when the gate voltage $V_g$ exceeds a threshold $V_{th}$ the device can be considered in an ON state, exhibiting a voltage/current characteristic substantially corresponding to that of a conventional FET. Conduction in the channel 12 is characterised in terms of a mass action of large numbers of charge carriers flowing along the channel. However, when the gate voltage $V_g$ reduces below the threshold $V_{th}$ the device assumes an OFF state in which the conductive characteristics of the path are determined by the characteristics of the MTJ structure 17. The fingers 17 induce in the channel a series of spaced potential wells corresponding to the configuration shown in Figure 7B. Thus, the current-voltage characteristic corresponds to that shown in Figure 5C and oscillates between a value in which theoretically, only single electron transport can occur by tunnelling through the barriers of the MTJ or electron transport is totally blocked by Coulomb blockade. In either of these conditions, the level of electron flow is reduced by many orders of magnitude as compared with the conventional leakage current of a FET. In practice, at room temperature, for the described 10nm spacing of the fingers 17, the Coulomb blockade presented to single electron transport along the channel may not be sufficient to control the entire leakage current and some leakage will occur due to thermal effects, but the Coulomb blockade effect will produce a very substantial reduction in the conventional leakage current. If, according to the invention, the spacing between the fingers 17 is reduced to less than 10nm, a more pronounced blocking effect will occur at room temperatures.

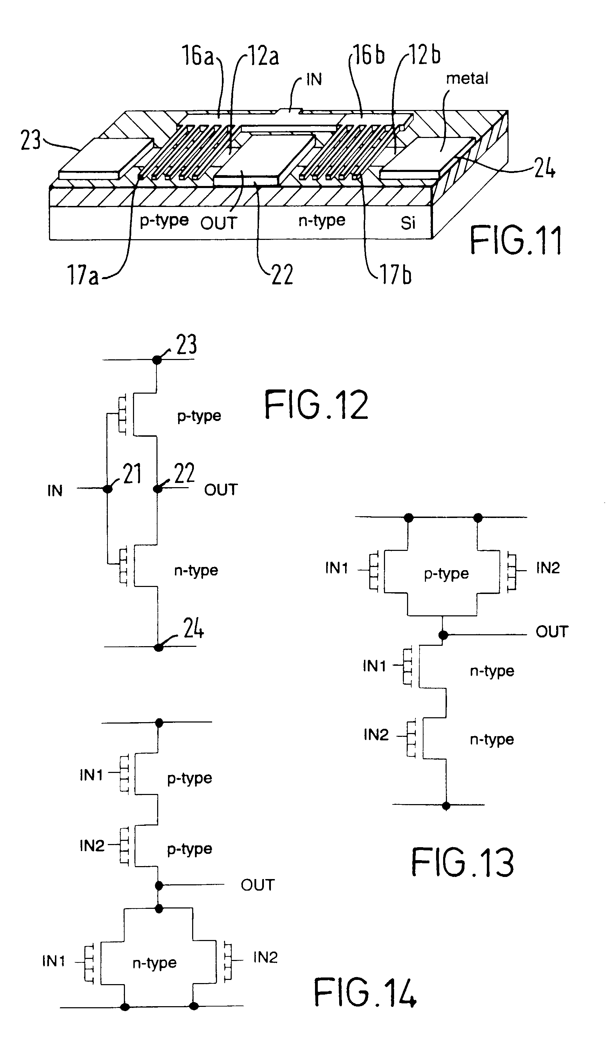

Referring now to Figure 10, this shows a logic symbol to be used for the device of Figure 8, which corresponds to a conventional FET symbol but with an interdigitated gate. Figure 11 shows how two devices can be produced with complementary p- and n-type channels, connected together as an inverter as shown in Figure 12. The device shown in Figure 11 essentially consists of two of the devices shown in Figure 8 but with respective p- and n-type channels 12a, 12b, their respective gates 16a, 16b being connected together to a common input 21. A common output metallization layer 22 is provided connected to the drains of the transistors and metallization regions 23, 24 are provided on the sources. Each gate 16a, 16b is provided with a respective interdigitated finger arrangement 17a, 17b to provide MTJs in each complementary channel, thereby inhibiting conventional current flow in the OFF state. Further circuits are shown in Figures 13 and 14 for NAND and NOR logic, using n- and p-type devices based on Figure 8. Further circuits using basic CMOS techniques can be developed.

As previously mentioned, the invention has the advantage that the conventional leakage current is reduced by many orders of magnitude. In conventional FET structures the leakage current is around 100pA. If $10^{10}$ gates in a LSI structure are considered, the leakage current gives power consumption of 1W. This power consumption is very large and is a problem for mobile equipment. For the device according to the invention shown in Figure 8, the OFF state current is estimated as

$$I \approx \frac{e}{CR} e^{-\left(\frac{e}{k_B T}\right)\left(\frac{e}{2C}\right)} \tag{2}$$

where R is the resistance of multiple tunnel junction when Coulomb blockade is not considered, and is around 10 GΩ corresponding to the leakage current of 100 pA. In order to use Coulomb blockade, the capacitance of the multiple tunnel junction, C, must be small such that $e/2C \sim 50k_BT/e \sim 1V$ at room temperature. Thus, the OFF state current is reduced by a factor of $\exp(-50) \sim 10^{-22}$. This means that "stand-by" power of $10^{10}$ gates LSI is around $10^{-22}$W, which is negligible, and orders of magnitude less than the conventional figure of 1W.

Alternative forms of MTJ structures have been reported, which could be used to implement the Coulomb blockade means. An example of a side gated MTJ is described in K. Nakazato, T.J. Thornton, J. White and H. Ahmed, Appl. Phys. Lett. 61, 3145 (1992). A split-gate structure is described in U. Meirav, M.A. Kastner and S.J. Wind, Phys. Rev. Lett. 65, 771 (1990). L.P. Kouwenhoven, A.T. Johnson, N.C. van der Vaart, C.J.P.M. Harmans and C.T. Foxon, Phys. Rev. Lett. 67, 1626 (1991). A double gate structure is disclosed in H. Matsouka, T. Ichiguchi, T. Yoshimura and E. Takeda, IEEE Electron Device Lett. 13, 20 (1992). These three structures have been considered hitherto for use in single-electron transistors but in accordance with the invention it has been appreciated that they could be modified such that a conventional mass action current could be used for the major controlled current flow, which could be switched to a substantially zero current in which the MTJ current blocking action predominates so as to produce a substantially zero leakage current.

## Claims

1. A controllable conduction device comprising:

   means defining a conductive path (12) for mass charge carrier flow; and
   means (16) for controlling mass charge carrier flow along the path, between relatively high and low conduction conditions;

   **characterised by** a plurality of elements (17) spaced apart by a distance of less than 10nm and operative by Coulomb blockade to inhibit mass charge carrier flow along the path in said low conduction condition.

2. A device according to claim 1 wherein said plurality of spaced elements produces a multiple tunnel junction.

3. A device according to claim 1 or 2 wherein said control means (16) comprises a gate to receive a control potential for controlling mass carrier flow along the path.

4. A device according to claim 3 wherein the plurality of spaced elements is embodied in the gate means (16).

5. A device according to claim 4 wherein the gate means (16) includes a conductive region extending transversely across the path, and the spaced elements comprise spaced fingers (17) formed in the conductive region for producing the multiple tunnel junction.

6. A device according to any preceding claim including a source (14) and a drain (15) for charge carriers flowing along the path.

7. A device according to any preceding claim including a semiconductor substrate (11), first and second complementary conduction channels (12a, 12b) formed on the substrate so as to define first and second of said conductive paths, first and second means (16a, 16b) for controlling mass charge carrier flow along the paths respectively and first and second tunnel junction means (17a, 17b) each comprising said spaced apart elements operative by Coulomb blockade to inhibit mass charge carrier flow along the paths respectively.

8. A method of fabricating a transistor including a channel (12) between a source (14) and a drain (15) with an overlying gate (16), characterised by forming in the gate a structure which includes a multiple tunnel junction configuration (17), comprising a plurality of spaced fingers with a spacing between them of less than 10nm and operative by Coulomb blockade to charge carrier tunneling for limiting current flow in the channel.

9. A method of driving a controllable conduction device between relatively high and low conduction conditions, the device comprising:

   means defining a conductive path (12) for mass charge carrier flow;
   means (16) for controlling mass charge carrier flow along the path, between relatively high and low conduction conditions; and
   means operative by Coulomb blockade to inhibit mass charge carrier flow along the path in said low conduction condition;

   such that in said low conduction condition, mass charge carrier flow along the conductive path (12) is inhibited by the Coulomb blockade effect.

## Patentansprüche

1. Vorrichtung mit steuerbarer Leitfähigkeit, mit

   einer Einrichtung, die einen leitfähigen Weg (12) für einen Massenladungsträgerfluß bildet, und

einer Einrichtung (16) zur Steuerung des Massenladungsträgerflusses längs des Weges zwischen Zuständen relativ hoher und niedriger Leitfähigkeit,

**gekennzeichnet durch** eine Vielzahl von Elementen (17), die in Abständen von weniger als 10 nm angeordnet sind und die durch Coulomb-Blockade bewirken, daß der Massenladungsträgerfluß längs des Weges in dem Zustand niedriger Leitfähigkeit gesperrt wird.

2. Vorrichtung nach Anspruch 1, bei der die Vielzahl von in Abständen angeordneten Elementen einen Mehrfachtunnelübergang erzeugt.

3. Vorrichtung nach Anspruch 1 oder 2, bei der die Steuereinrichtung (16) ein Gate aufweist, das ein Steuerpotential zur Steuerung des Massenladungsträgerflusses längs des Weges empfängt.

4. Vorrichtung nach Anspruch 3, bei der die Vielzahl von in Abständen angeordneten Elementen in der Gate-Einrichtung (16) verwirklicht ist.

5. Vorrichtung nach Anspruch 4, bei der die Gate-Einrichtung (16) einen leitfähigen Bereich enthält, der sich quer über den Weg erstreckt, und bei der die in Abständen angeordneten Elemente in Abständen angeordnete Finger (17) aufweisen, die in dem leitfähigen Bereich gebildet sind, um den Mehrfachtunnelübergang zu erzeugen.

6. Vorrichtung nach einem der vorhergehenden Ansprüche, die eine Source (14) und einen Drain (15) für längs des Weges fließende Ladungsträger enthält.

7. Vorrichtung nach einem der vorhergehenden Ansprüche, mit einem Halbleitersubstrat (11), ersten und zweiten komplementären Leitungskanälen (12a, 12b), die auf dem Substrat gebildet sind, um erste und zweite leitfähige Kanäle zu bilden, ersten und zweiten Einrichtungen (16a, 16b) zur Steuerung des Massenladungsträgerflusses längs der jeweiligen Wege und ersten und zweiten Tunnelübergangseinrichtungen (17a, 17b), die jeweils die in Abständen angeordneten Elemente aufweisen, die durch Coulomb-Blockade bewirken, daß der Massenladungsträgerfluß längs der jeweiligen Wege gesperrt wird.

8. Verfahren zur Herstellung eines Transistors, der einen Kanal (12) zwischen einer Source (14) und einem Drain (15) mit einem darüberliegenden Gate (16) enthält, **dadurch gekennzeichnet, daß** in dem Gate eine Struktur gebildet wird, die eine Mehrfachtunnelübergangs-Anordnung (17) enthält, die eine Vielzahl von in Abständen angeordneten Fingern aufweist, mit einem Abstand von weniger als 10 nm dazwischen, die durch Coulomb-Blockade ein Ladungsträgertunneln bewirken, um den Stromfluß in dem Kanal zu begrenzen.

9. Verfahren zur Ansteuerung einer Vorrichtung mit steuerbarer Leitfähigkeit zwischen Zuständen relativ hoher und niedriger Leitfähigkeit, wobei die Vorrichtung folgendes aufweist:

eine Einrichtung, die einen leiffähigen Weg (12) für einen Massenladungsträgerfluß bildet, eine Einrichtung (16) zur Steuerung des Massenladungsträgerflusses längs des Weges zwischen Zuständen relativ hoher und niedriger Leitfähigkeit, und eine Einrichtung, die durch Coulomb-Blockade bewirkt, daß der Massenladungsträgerfluß längs des Weges in dem Zustand niedriger Leitfähigkeit gesperrt wird,

derart, daß in dem Zustand niedriger Leitfähigkeit der Massenladungsträgerfluß längs des leiffähigen Weges (12) durch die Coulomb-Blockadewirkung gesperrt wird.

**Revendications**

1. Dispositif à conduction commandée comprenant :

un moyen définissant une ligne conductrice (12) pour la circulation massive des porteurs de charges, et un moyen (16) destiné à commander la circulation massive des porteurs de charges le long de la ligne, entre des états de conduction relativement haute et relativement basse,

**caractérisé par** une pluralité d'éléments (17) espacés sur une distance inférieure à 10 mn et fonctionnant grâce au blocage de Coulomb pour inhiber la circulation massive des porteurs de charges le long de la ligne dans ledit état de conduction basse.

2. Dispositif selon la revendication 1, dans lequel ladite pluralité d'éléments espacés produit une jonction multiple à effet tunnel.

3. Dispositif selon la revendication 1 ou 2, dans lequel ledit moyen de commande (16) comprend une grille afin de recevoir un potentiel de commande destiné à commander la circulation massive des porteurs le long de la ligne.

**4.** Dispositif selon la revendication 3, dans lequel la pluralité d'éléments espacés est mise en oeuvre dans le moyen de grille (16).

**5.** Dispositif selon la revendication 4, dans lequel le moyen de grille (16) comprend une région conductrice s'étendant transversalement en travers de la ligne, et les éléments espacés comprennent des doigts espacés (17) formés dans la région conductrice afin de produire la jonction multiple à effet tunnel.

**6.** Dispositif selon l'une quelconque des revendications précédentes comprenant une source (14) et un drain (15) destinés à la circulation des porteurs de charges le long de la ligne.

**7.** Dispositif selon l'une quelconque des revendications précédentes comprenant un substrat semiconducteur (11), des premier et second canaux à conduction complémentaire (12a, 12b) formés sur le substrat de façon à définir des première et seconde lignes parmi lesdites lignes conductrices, des premier et second moyens (16a, 16b) destinés à commander la circulation massive des porteurs de charges le long des lignes, respectivement, et des premier et second moyens de jonction à effet tunnel (17a, 17b), chacun comprenant lesdits éléments espacés fonctionnant grâce au blocage de Coulomb pour inhiber la circulation massive des porteurs de charges le long des lignes, respectivement.

**8.** Procédé de fabrication d'un transistor comprenant un canal (12) entre une source (14) et un drain (15) avec une grille superposée (16), caractérisé par la formation dans la grille d'une structure qui comprend une configuration de jonction multiple à effet tunnel (17), comprenant une pluralité de doigts espacés, présentant un espacement entre eux inférieur à 10 nm et fonctionnant grâce au blocage de Coulomb pour obtenir un effet tunnel pour les porteurs de charges en vue de limiter la circulation du courant dans le canal.

**9.** Procédé d'attaque d'un dispositif à conduction commandée entre des états de conduction relativement haute et relativement basse, le dispositif comprenant :

un moyen définissant une ligne conductrice (12) destinée à la circulation massive des porteurs de charges,
un moyen (16) destiné à commander la circulation massive des porteurs de charges le long de la ligne, entre des états de conduction relativement haute et relativement basse, et
un moyen fonctionnant grâce au blocage de Coulomb pour inhiber la circulation massive des porteurs de charges le long de la ligne dans ledit état de conduction basse,

de sorte que dans ledit état de conduction basse, la circulation massive des porteurs de charges le long de la ligne conductrice (12) est inhibée par l'effet de blocage de Coulomb.

# FIG.1

current
Id

Vd

gate

Vg

gate

5 2

drain

electron channel

3

source

4

semiconductor substrate

1

# FIG.2

Id

ON

a mass of
electrons flows

leakage
current

OFF

Vg

Vth

X

tunnel junction

conductive
region

7

6

8

Id

Vd

# FIG.3

10a

9

Vg

gate capacitor
Cg

10b

6

-ne

# FIG.4

+++++++

$C_g V_g$

9

FIG.5

E

FIG.5a

$\dfrac{C_g V_g}{e}$

n

0  1  2  3  4

FIG.5b

0  1  2  3  4  5

Id

FIG.5c

$\dfrac{C_g V_g}{e}$

0  1  2  3  4

B1          B2

$E_f$  Electron energy

Fermi
energy

position

X

FIG.6a 'ON' state          10a          10b

FIG.6

B1          B2

Fermi
energy  $E_f$

Electron energy

position

X

FIG.6b 'OFF' state

FIG.7a 'ON' state

FIG.7

FIG.7b 'OFF' state

FIG.8

FIG.9

FIG.10

FIG.11

FIG.12

FIG.13

FIG.14